# EUROPÄISCHE PATENTSCHRIFT

(11) **EP 2 284 884 B1**
(45) Veröffentlichungstag und Bekanntmachung des Hinweises auf die Patenterteilung: **07.08.2019**
(21) Anmeldenummer: 10006521.8
(22) Anmeldetag: 23.06.2010
(51) Int. Cl.: H01L 23/367

(54) **Anordnung mit einer Kühleinrichtung und einem Leistungshalbleitermodul**
Assembly with a cooling device and a high-performance semi-conductor
Agencement doté d'un dispositif de refroidissement et d'un module semi-conducteur de puissance

(30) Priorität: 12.08.2009 DE 102009037259
(43) Veröffentlichungstag der Anmeldung: 16.02.2011
(73) Patentinhaber: SEMIKRON Elektronik GmbH & Co. KG, 90431 Nürnberg (DE)
(72) Erfinder: Frank, Thomas, 91207 Lauf (DE)

(56) Entgegenhaltungen:
- EP-A2- 0 206 980
- EP-A2- 1 873 828
- DE-A1- 10 200 019
- DE-U1- 29 601 776
- US-A1- 2003 178 181
- US-A1- 2004 118 550
- US-A1- 2005 000 682

## Beschreibung

Die vorliegende Erfindung betrifft eine Anordnung mit einer Kühleinrichtung vorzugsweise zur Luftkühlung von Leistungshalbleitermodulen

Es sind verschiedenartigste Kühleinrichtungen für Leistungshalbleitermodule bekannt, um die im Betrieb entstehend Wärme von im Inneren der Leistungshalbleitermodulen angeordneten Leistungshalbleiterbauelementen abzuleiten. Um die Temperatur des Leistungshalbleiterbauelements so gering wie möglich zu halten, sind sowohl der Aufbau des Leistungshalbleitermoduls als auch die Verbindungstechnik zur Kühleinrichtung hin von besonderer Bedeutung. Dabei sind beispielhaft die Wärmeleitfähigkeit und der thermische Ausdehnungskoeffizient der verwendeten Materialien für die Kühleinrichtung wesentlich. Darüber hinaus werden weitere Anforderungen an die Anordnung von Leistungshalbleitermodul und Kühleinrichtung gestellt, wie beispielhaft die Beständigkeit der Anordnung aus Kühleinrichtung gegenüber Betriebseinflüsse wie sie beispielhaft beim Betrieb einer derartigen Anordnung in einem Gabelstaplers auftreten.

Bekannte Kühleinrichtungen bestehen häufig aus Strang- oder Fließpressprofilen, mit einem Grundkörper und hieran angeordnet einer Mehrzahl von Kühlrippen, die von einem Kühlmedium in Längsrichtung durchströmt werden. Der Wärmeeintrag der Verlustwärme erfolgt ausgehend vom Grundkörper in Richtung der Kühlrippen.

Aus dem Stand der Technik beispielhaft der DE 29601776 U1 ist es bekannt, eine Kühleinrichtung aus stranggepressten Aluminium oder anderem Leichtmetall auszubilden. Hierin ist offenbart die Kühlrippen in gleichmäßigem Abstand zueinander an einer Grundplatte anzuordnen indem sie in einer Einsatznut der Grundplatte festliegen.

Nachteilig an Anordnungen gemäß dem Stand der Technik ist die Neigung der Kühleinrichtung, insbesondere der Kühlrippen, durch Betriebseinflüsse zu schwingen. Derartige Schwingungen, speziell im oder nahe am Resonanzfall übertragen sich auf das Leistungshalbleitermodul und beeinträchtigen dessen Lebensdauer und / oder Zuverlässigkeit.

Aus der US 2004/0118550 A1 ist ein Kühlkörper bei dem die Dichte der Kühlrippen auswählbar ist, bekannt.

Aus der EP 0206980 A2 ist ein Kühlkörper für Halbleiterbauelemente mit in Abstand zueinander von einer Grundplatte abragenden Kühlrippen bekannt.

Aus der EP 1873828A2 ist ein Kühlkörper mit einer Grundplatte, von der sich Kühlrippen weg erstecken, bekannt.

Die Aufgabe der vorliegenden Erfindung ist es daher, eine Anordnung mit einer Kühleinrichtung und einem Leistungshalbleitermodul vorzustellen, wobei das Schwingungsverhalten der Kühleinrichtung insbesondere der Kühlrippen bei externer Anregung verbessert wird.

Erfindungsgemäß wird die Aufgabe mit den Merkmalen des Anspruchs 1 gelöst. Weitere vorteilhafte Ausgestaltungen sind in den Unteransprüchen genannt.

Bei der erfindungsgemäßen Anordnung mit einem Leistungshalbleitermodul und mit einer Kühleinrichtung weist das Leistungshalbleitermodul mindestens ein Substrat mit hierauf angeordneten, Wärme erzeugenden, Leistungshalbleiterbauelementen auf.

Die Kühleinrichtung der erfindungsgemäßen Anordnung weist einen Grundkörper und mindestens zwei Ausgestaltungen von ersten und zweiten Kühlrippen auf, die einstückig mit dem Grundkörper verbunden sind. Diese Kühlrippen sind in ihrer Grundform als flächige Formkörper ausgebildet und in ihrer Höhenausdehnung parallel zur Flächennormalen der Hauptfläche des Grundkörpers angeordnet. Erfindungsgemäß unterscheiden sich die ersten und zweiten Kühlrippen in ihrer Masse, wobei dieser Masseunterschied durch unterschiedliches Volumen bei gleichem Werkstoff erreicht wird.

Es ist bevorzugt, wenn die Masse der zweiten Kühlrippen das 1,2 bis 3 - fache, insbesondere das 1,2 bis 1,8 - fache, der Masse der ersten Kühlrippen aufweisen. Dies kann bei gleichem Werkstoff der ersten und zweiten Kühlrippen bevorzugt durch Variation der mittleren Dicke bei gleicher Höhenausdehnung erfolgen. Die ersten und zweiten Kühlrippen weisen somit bei externer Anregung unterschiedliche Amplituden der Auslenkung auf, wodurch das Resonanzverhalten und damit das gesamte Schwingungsverhalten der Kühleinrichtung verbessert werden.

Die Anordnung der Kühlrippen ist alternierend in der Folge "ABABAB".

Weiterhin sind auf der Oberfläche der ersten und zweiten Kühlrippen Konturen angeordnet um den Wärmeübergang auf ein Kühlmedium zu verbessern. Häufig werden die ersten und / oder zweiten Kühlrippen ein Querschnittsprofil aufweisen, das sich in Richtung der Flächennormalen verjüngt.

Der erfinderische Gedanke wird anhand der Ausführungsbeispiele in den Fig. 1 bis Fig. 2 näher erläutert.

Fig. 1 zeigt eine Vorderansicht der erfindungsgemäßen Anordnung mit einer Kühleinrichtung und mit einem Leistungshalbleitermodul.

Fig. 2 zeigt eine dreidimensionale Ansicht einer Kühleinrichtung einer der erfindungsgemäßen Anordnung.

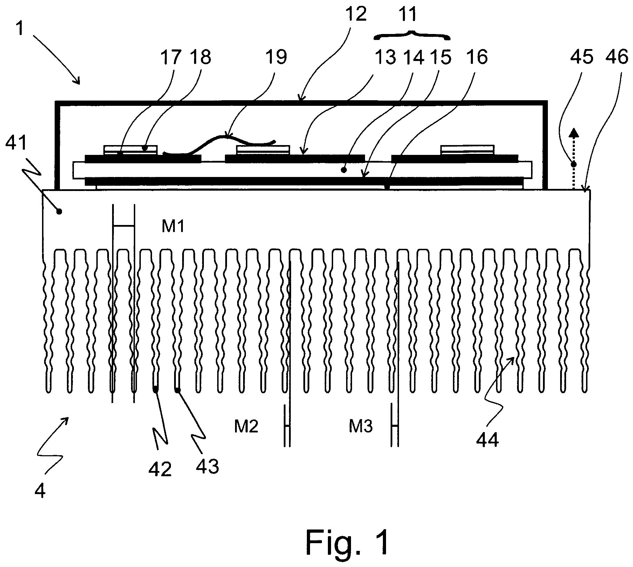

Fig. 1 zeigt eine Vorderansicht der erfindungsgemäßen Anordnung mit einer Kühleinrichtung (4) und einem Leistungshalbleitermodul (1) Das Leistungshalbleitermodul (1) weist ein Gehäuse (3), beispielhaft aus Kunststoff, auf, welches auf Substraten (11) angeordnete Bauelemente wie Leistungshalbleiterbauelemente (18) und Verbindungselemente (19) umschließt. Das Substrat (11) weist einen Isolierstoffkörper (14) mit hieran angeordneten Metallisierungen (13, 15) auf. Auf der Innenseite sind diese Metallisierungen in sich strukturiert während sie auf der gegenüberliegenden Seite in Richtung der Kühleinrichtung (4) unstrukturiert sind. Auf der strukturierten Metallisierung (13) sind Leistungshalbleiterbauelemente, beispielhaft Dioden oder Transistoren, und Verbindungselemente (19), beispielhaft Bondverbindungen, angeordnet.

Die Leistungshalbleiterbauelemente (18) sind über eine elektrisch leitende stoffschlüssige Verbindung (17) beispielhaft Löt-, Drucksinter- oder Schweißverbindung mit der strukturierten Metallisierung (13) des Substrats (11) verbunden. Die unstrukturierte Metallisierung (15), ist beispielhaft mittels einer kraft- oder stoffschlüssigen Verbindung mit der Kühleinrichtung verbunden.

Als stoffschlüssige Verbindungen (16) können beispielhaft Löt- oder Drucksinterverbindung gewählt werden. Als kraftschlüssige Verbindung bietet sich eine Druckbeaufschlagung beispielhaft durch Klammer-, Schraub- oder Steckverbindung an.

Die Kühleinrichtung (4) weist einen Grundkörper (41) auf, von dem parallel zur Flächennormalen (45) seiner Hauptfläche (46) erste (42) und zweite Kühlrippen (43) wegstehen und alternierend in der Folge "ABABA" angeordnet sind. Diese Kühlrippen (42,43) sind einstückig mit dem Grundkörper (41) ausgebildet.

Die Kühleinrichtung (4) weist zwischen den ersten Kühlrippen (42) und zweiten Kühlrippen (43) einen mittleren Abstand (M1) auf, der über die gesamte Kühleinrichtung (4) in Längsrichtung des Grundkörpers (41) konstant ist. Die ersten Kühlrippen (42) weisen eine erste mittlere Dicke (M2) und die zweiten Kühlrippen eine zweite mittlere Dicke (M3) auf bedingt durch die unterschiedlichen Massen der ersten Kühlrippen (42) und der zweiten Kühlrippen (43) bei gleicher Höhenausdehnung und gleichem Werkstoff.

Weiterhin dargestellt ist, dass sich die Kühlrippen (42, 43) vom Grundkörper (41) der Kühleinrichtung (4) weg verjüngen. Auf der Oberfläche der ersten (42) und zweiten Kühlrippen (43) sind Konturen (44) angeordnet, welche in Richtung der Flächennormalen der Hauptfläche (46) des Grundkörpers (41) auf der Oberfläche des ersten (42) sowie des zweiten Kühlrippens (43) wellenförmig verlaufen. Durch diese Konturen (44) vergrößert sich die Oberfläche der Kühlrippen (42, 43) und somit die Fläche zur Wärmeübertragung an die Umgebung.

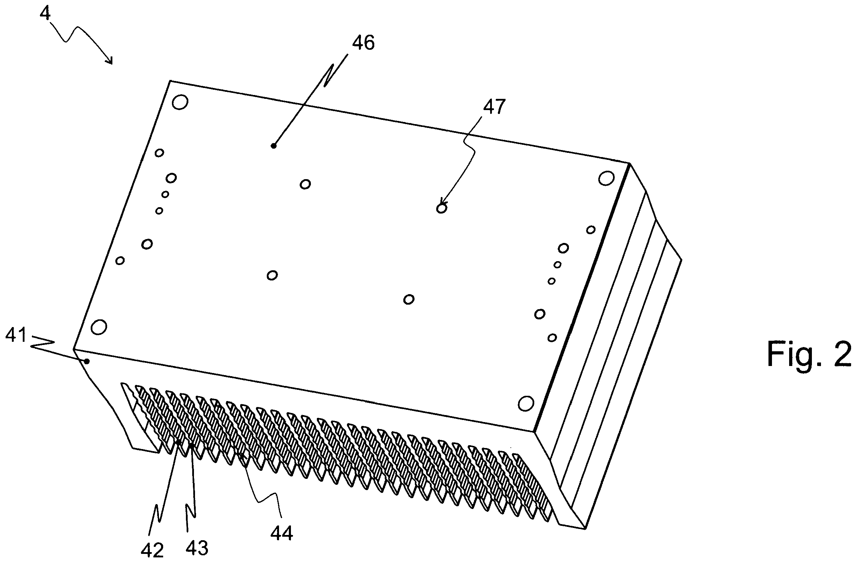

Fig. 2 zeigt eine dreidimensionale Ansicht einer Kühleinrichtung (4) der erfindungsgemäßen Anordnung. Die Kühleinrichtung (4) weist einen Grundkörper (41) auf und in Querrichtung des Grundkörpers (41) alternierend angeordnete erste Kühlrippen (42) und zweite Kühlrippen (43). Dargestellt ist weiter die Hauptfläche (46) der Kühleinrichtung (4) mit den Befestigungseinrichtungen (47) zur Anordnung des Leistungshalbleitermoduls (1). Die Befestigung bei dieser Ausbildung erfolgt über eine kraftschlüssige Verbindung die über Schraubverbindungen auf das Leistungshalbleitermodul eingeleitet werden.

### Bezugszeichenliste

- 1.: Leistungshalbleitermodul
- 4.: Kühleinrichtung
- 11.: Substrat
- 12.: Gehäuse
- 13.: Metallisierung
- 14.: Isolierstoffkörper
- 15.: unstrukturierte Metallisierung
- 16.: stoffschlüssige Verbindung
- 17.: stoffschlüssige Verbindung
- 18.: Leistungshalbleiterbauelement
- 19.: Verbindungselement
- 41.: Grundkörper
- 42.: erste Kühlrippe
- 43.: zweite Kühlrippe
- 44.: Konturen
- 45.: Flächennormale
- 46.: Hauptfläche
- 47.: Befestigungseinrichtung
- M1.: mittlerer Abstand
- M2.: mittlere Dicke des ersten Kühlrippens
- M3.: mittlere Dicke des zweiten Kühlrippens

## Patentansprüche

1. Anordnung mit einem Leistungshalbleitermodul (1) und mit einer Kühleinrichtung (4), die mindestens aufweist einen Grundkörper (41) mit Befestigungseinrichtung (47) zur Anordnung des Leistungshalbleitermoduls (1) und mindestens zwei Ausgestaltungen von ersten und zweiten Kühlrippen (42, 43), die jeweils einstückig mit dem Grundkörper (41) verbunden sind, wobei die jeweiligen ersten und zweiten Kühlrippen (42, 43) in ihrer Grundform als flächige Formkörper ausgebildet sind und derartig zu dem Grundkörper (41) der Kühleinrichtung (4) angeordnet sind, dass sie in ihrer Höhenausdehnung parallel zur Flächennormalen (45) der Hauptfläche (46) des Grundkörpers (41) angeordnet sind und ihre Längsausdehnung senkrecht zu dieser Flächennormalen verläuft, wobei die jeweils ersten und zweiten Kühlrippen (42, 43) verschiedene Massen aufweisen, wobei die ersten und zweiten Kühlrippen den gleichen Werkstoff aber unterschiedliches Volumen aufweisen, **dadurch gekennzeichnet, dass** die jeweiligen ersten und zweiten Kühlrippen (42, 43) in einer Folge "ABABA" angeordnet sind, wobei auf der Oberfläche der ersten und zweiten Kühlrippen (42, 43) Konturen (44) angeordnet sind, welche in Richtung der Flächennormalen (45) der Hauptfläche (46) des Grundkörpers (41) auf der Oberfläche der ersten und der zweiten Kühlrippen (42, 43) wellenförmig verlaufen.

2. Anordnung nach Anspruch 1,
wobei die unterschiedlichen Massen der Kühlrippen (42, 43) bei gleicher Höhenausdehnung durch eine unterschiedliche mittlerer Dicke (M2, M3) parallel zur Höhenausdehnung des Grundkörpers (41) ausgebildet sind.

3. Anordnung nach Anspruch 1,
wobei die Masse einer zweiten Kühlrippe (43) das 1,2 bis 3 - fache insbesondere das 1,2 bis 1,8 - fache der Masse einer ersten Kühlrippe (42) beträgt.

## Claims

1. Assembly having a high-performance semiconductor module (1) and having a cooling device (4) which has at least a base (41) with fixing device (47) for arranging the high-performance semiconductor module (1) and at least two configurations of first and second cooling ribs (42, 43) which are each connected in one piece to the base (41), the respective first and second cooling ribs (42, 43) being formed in their outline as flat moulded bodies and being arranged in relation to the base (41) of the cooling device (4) in such a way that they are arranged with their vertical extent parallel to the surface normal (45) to the main surface (46) of the base (41) and their longitudinal extent extends at right angles to this surface normal, the respective first and second cooling ribs (42, 43) having different masses, the first and second cooling ribs having the same material but different volumes, **characterized in that** the respective first and second cooling ribs (42, 43) are arranged in a sequence "ABABA", contours (44) being arranged on the surface of the second cooling ribs (42, 43), extending in the form of waves on the surface of the first and the first and second cooling ribs (42, 43) in the direction of the surface normal (45) to the main surface (46) of the base (41).

2. Assembly according to Claim 1,
wherein, given the same vertical extent, the different masses of the cooling ribs (42, 43) are formed by a different average thickness (M2, M3) parallel to the vertical extent of the base (41).

3. Assembly according to Claim 1,
wherein the mass of a second cooling rib (43) is 1.2 to 3 times, in particular 1.2 to 1.8 times, the mass of a first cooling ribs (42).

## Revendications

1. Arrangement avec un module semi-conducteur de puissance (1) et un dispositif de refroidissement (4), comportant au moins un corps principal (41) avec un dispositif de fixation (47) pour agencer le module semi-conducteur de puissance (1) et au moins deux configurations de premières et deuxièmes ailettes de refroidissement (42, 43), qui sont respectivement reliées d'une pièce au corps principal (41), dans lequel les premières et deuxièmes ailettes de refroidissement (42, 43) sont conçues dans leur forme fondamentale comme corps conformés plats et sont agencées au corps principal (41) du dispositif de refroidissement (4) de telle sorte qu'elles sont agencées dans leur étendue en hauteur parallèlement aux normales à la surface (45) des surfaces principales (46) du corps principal (41) et que leur étendue en longueur est perpendiculaire à ces normales à la surface, dans lequel les premières et deuxièmes ailettes de refroidissement (42, 43) respectives possèdent des masses différentes, dans lequel les premières et deuxièmes ailettes de refroidissement sont faites du même matériau mais possèdent des volumes différents, **caractérisé en ce que** les premières et deuxièmes ailettes de refroidissement (42, 43) respectives sont agencées dans une série « ABABA », dans lequel des contours (44) sont agencés sur les premières et deuxièmes ailettes de refroidissement (42, 43), lesquels ondulent sur la surface des premières et deuxièmes ailettes de refroidissement (42, 43) dans la direction des normales aux surfaces (45) de la surface principale (46) du corps principal (41).

2. Agencement selon la revendication 1, dans lequel les différentes masses des ailettes de refroidissement (42, 43) sont formées, à étendue en hauteur égale, par une épaisseur moyenne (M2, M3) différente parallèlement à l'étendue en hauteur du corps principal (41).

3. Agencement selon la revendication 1, dans lequel la masse d'une deuxième ailette de refroidissement (43) est de 1,2 à 3 fois - tout particulièrement de 1,2 à 1,8 fois - la masse d'une première ailette de refroidissement (42).
